# EUROPÄISCHE PATENTSCHRIFT

(11) **EP 0 296 683 B1**
(45) Veröffentlichungstag und Bekanntmachung des Hinweises auf die Patenterteilung: **19.01.1994**
(21) Anmeldenummer: 88201273.5
(22) Anmeldetag: 21.06.1988
(51) Int. Cl.: H03K 5/12, H03G 7/00, H03K 5/01, H04N 5/14

(54) **Verfahren und Schaltungsanordnung zum Vermindern von Störungen**
Method and circuit for reducing interference
Méthode et circuit pour atténuer les parasites

(30) Priorität: 16.03.1988 DE 3808737; 24.06.1987 DE 3720871
(43) Veröffentlichungstag der Anmeldung: 28.12.1988
(73) Patentinhaber: Philips Patentverwaltung GmbH, 22335 Hamburg (DE); Philips Electronics N.V., 5621 BA Eindhoven (NL)
(72) Erfinder: Harlos, Hartmut, D-2000 Hamburg 65 (DE); Kelting, Peter, D-2200 Elmshorn (DE)
(74) Vertreter: Peters, Carl Heinrich, Dipl.-Ing.

(56) Entgegenhaltungen:
- CH-A- 658 963
- DE-B- 2 064 731
- DE-B- 2 114 149
- DE-C- 3 136 217
- GB-A- 2 124 844
- US-A- 4 536 796
- J.Markus,"Sourcebook of Electronic Circuits",McGraw-Hill Book Company 1968, Seite 330,Schaltung "Video Signal Processor"

## Beschreibung

Die Erfindung bezieht sich auf eine Schaltungsanordnung zum Vermindern von Störungen beim Versteilern der Flanken eines Nutzsignales durch Verknüpfung mit einem daraus abgeleiteten Versteilerungssignal, das nur bei Überschreiten einer vorgegebenen Grenzamplitude das Nutzsignal beeinflußt, mit einer Versteilerungssignalstufe zum Liefern des Versteilerungssignales und einer Störunterdrückungsstufe, in der ein Störunterdrückungssignal erzeugt und dem Versteilerungssignal überlagert wird, wobei die Versteilerungssignalstufe das Versteilerungssignal an zwei Gegentakt-Stromausgängen abgibt.

Aus der US-PS 4,536,796, insbesondere Fig. 3 mit zugehöriger Beschreibung, ist eine Schaltungsanordnung zum Vermindern von Störungen bekannt, die aus einem Videosignal einerseits über einen Differenzverstärker mit linearer Verstärkung ein Versteilerungssignal und andererseits über einen zweistufigen Begrenzerverstärker ein sogenanntes "Coring"-Signal bildet. Das vom linearen Differenzverstärker an zwei Gegentaktausgängen abgegebene, als "Peaking"-Signal bezeichnete Signal wird mit dem "Coring"-Signal zu einem Versteilerungssignal mit Störunterdrückung ("Cored-Peaking"-Signal) überlagert und anschließend mit dem Videosignal verknüpft.

Aus der DE-PS 31 36 217 ist eine Schaltungsanordnung zur Verarbeitung eines Farbvideosignales bekannt, die eine Anordnung zur Schärfekorrektur umfaßt. Darin wird aus dem Helligkeitssignal des Farbvideosignals ein Teilsignal gebildet und dem Helligkeitssignal zur Schärfekorrektur hinzugefügt. Die Schärfekorrektur wird erst dann wirksam, wenn das Teilsignal einen bestimmten Amplitudenmindestwert überschreitet, der durch die Einstellung einer Schwellwerteinrichtung bestimmt wird. Diese wird durch einen amplitudenabhängig gesteuerten Verstärker dargestellt, dessen Verstärkungsfaktor praktisch Null ist, bis der Schwellwert erreicht ist, und der dann einen endlichen Wert annimmt.

Bei Anordnungen zur Schärfekorrektur, auch Aperturkorrektur-Schaltung genannt, werden die höherfrequenten Signalanteile stärker in ihrer Amplitude angehoben als die niederfrequenten Signalanteile. Dadurch entstehen steilere Signalflanken, was z.B. beim Videosignal eine verbesserte Bildschärfe zur Folge hat. Allerdings werden bei der Erzeugung des Teilsignales auch Rauschsignalanteile in ihrer Amplitude angehoben. Insbesondere niederfrequente Videosignalanteile geringer Amplitude, wie sie bei der Darstellung gleichförmiger Bildflächen auftreten, werden dadurch in ihrer Qualität merkbar verschlechtert, wenn sie verrauscht sind. Die genannte Schwellwerteinrichtung wirkt dem entgegen, in dem sie Rauschsignalanteile bis zur Grenzamplitude im Teilsignal unterdrückt.

Die Erfindung hat die Aufgabe, eine Schaltungsanordnung der eingangs genannten Art derart auszubilden, daß dafür ein sehr einfacher Schaltungsaufbau möglich ist, insbesondere im Hinblick auf eine platzsparende Integration auf einem Halbleiterkristall.

Diese Aufgabe wird bei der eingangs genannten Schaltungsanordnung dadurch gelöst, daß von den Gegentakt-Stromausgängen in der Störunterdrückungsstufe jeder mit einem Reihenwiderstand sowie dem Steueranschluß eines von zwei Transistoren verbunden ist, deren Hauptstrompfade an ihrem einen Ende miteinander an eine Speisestromquelle angeschlossen und an ihrem anderen Ende mit dem vom Gegentakt-Stromausgang abgewandten Anschluß des zugehörigen Reihenwiderstandes verbunden sind.

Die erfindungsgemäße Schaltungsanordnung ist für die Aufbereitung jedes Signales anwendbar, dessen Flanken beispielsweise durch die Übertragung über einen frequenzbandbegrenzenden Übertragungskanal verschliffen sind. Vorzugsweise eignet es sich für die Aufbereitung eines Fernsehsignales zur Erhöhung der Bildschärfe. Die dabei zur Rauschunterdrückung verwendete Schwellwerteinrichtung und insbesondere der diese bildende amplitudenabhängig gesteuerte Verstärker sind dabei einerseits verhältnismäßig aufwendig aufgebaut und können andererseits selbst neue, zusätzliche Störungen erzeugen, die dem Fernsehsignal dann überlagert werden. Diese Nachteile werden durch die erfindungsgemäße Schaltungsanordnung vermieden. Es zeigt sich nämlich, daß die Überlagerung des Versteilerungssignales mit dem gegenphasigen, amplitudenbegrenzten Störunterdrückungssignal sehr einfach ausführbar ist und eine wirksame Unterdrückung der Störungen im Versteilerungssignal ergibt, ohne dabei gleichzeitig neue merkliche Störungen hervorzurufen. Insgesamt werden alle Störungen mit mäßiger Amplitude ausgelöscht, während Anteile höherer Amplitude im Versteilerungssignal um die Grenzamplitude reduziert erhalten bleiben.

Bei der erfindungsgemäßen Schaltungsanordnung enthält die Störunterdrückungsstufe lediglich die Reihenwiderstände, die Transistoren und die Stromquelle und ist damit sehr einfach aufgebaut. Der Strom der Speisestromquelle kann einstellbar sein. Durch ihn wird unmittelbar die Grenzamplitude bestimmt, die dadurch leicht steuerbar ist. Da bei der beschriebenen Anordnung lediglich die Reihenwiderstände in die Signalübertragungswege eingefügt sind, entstehen einerseits in der Störunterdrückungsstufe keine neuen Störungen, andererseits werden die Impedanzverhältnisse durch Veränderungen der Grenzamplitude nicht geändert. Es sind dann trotz der Einstellmöglichkeit stets identische Signalübertragungseigenschaften gegeben.

Um eine gleichmäßige Grenzamplitude beiderseits des Arbeitspunktes der Versteilerungssignalstufe zu gewährleisten, wird dieser Arbeitspunkt stabilisiert. Das geschieht vorzugsweise durch eine Arbeitspunkt-Regelstufe, die aus einem Vergleich zweier aus den Gegentakt-Stromausgängen abgeleiteter Spannungen einen Zusatzgleichstrom zum Nachregeln des Gleichstromes in wenigstens einem der Gegentakt-Stromausgänge bildet. Damit wird erreicht, daß der Arbeitspunkt stets genau in der Mitte des durch die Grenzamplituden bestimmten Aussteuerungsbereiches liegt, der wiederum je nach Größe der zu unterdrückenden Störungen nur einen kleinen Teil des gesamten Aussteuerungsbereiches für das Versteilerungssignal ausmacht. Vorzugsweise werden die Gleichströme in den Gegentakt-Stromausgängen vom Zusatzgleichstrom gegenläufig nachgeregelt, um Arbeitspunktverschiebungen zu vermeiden.

Einen besonders einfachen und wirksamen Aufbau für eine Arbeitspunkt-Regelstufe erhält man dadurch, daß diese eine Konstantstromquelle umfaßt, deren Strom in zwei den aus den Gegentakt-Stromausgängen abgeleiteten Spannungen entsprechende Anteile aufgeteilt wird, wobei der Zusatzgleichstrom der Differenz dieser Anteile entspricht. Eine Variation des Stromes von der Konstantstromquelle ermöglicht dann eine einfache Einstellung der Empfindlichkeit der Regelung. Der Zusatzgleichstrom kann an verschiedenen Stellen der Schaltungsanordnung eingespeist werden, beispielsweise in der Art einer parallel geschalteten Stromquelle an einem der Gegentakt-Stromausgänge oder bevorzugt in die Versteilerungssignalstufe selbst zum Nachstellen der darin für eine Arbeitspunkteinstellung benötigten Gleichströme.

Die erfindungsgemäße Schaltungsanordnung ist darüber hinaus vorteilhaft für einen Betrieb mit niedriger Versorgungsspannung verwendbar. Vorzugsweise können das Versteilerungssignal und/oder das Störunterdrückungssignal vor dem Überlagern über wenigstens eine Stromspiegelanordnung geführt werden. Mit derartigen Stromspiegelanordnungen werden Signalströme, die das Versteilerungssignal und/oder das Störunterdrückungssignal bilden, mit großer Genauigkeit übertragen, ohne daß dafür eine zu große Anzahl von Bauelementen oder Signalverarbeitungsstufen zwischen zwei Schaltungspunkten, die nur eine geringe Spannungsdifferenz führen, in Reihe geschaltet werden müssen. Insbesondere ist wenigstens eine der Stromspiegelanordnungen im Signalweg des Versteilerungssignals zwischen den von den Gegentakt-Stromausgängen abgewandten Anschlüssen der Reihenwiderstände und einem Schaltungspunkt für das Überlagern des Störunterdrückungssignals angeordnet. Zwar wird durch die Stromspiegelanordnungen ein zusätzlicher Schaltungsaufwand hervorgerufen, der jedoch angesichts der durch die Erfindung erzielten Vereinfachungen vertretbar ist.

Zur Vermeidung der Übersteuerung des Nutzsignals dient vorzugsweise eine Spannungsbegrenzungsstufe, die das mit dem Störunterdrückungssignal überlagerte Versteilerungssignal in der dem Nutzsignal gleichgerichteten Polarität derart begrenzt, daß die Amplitude des mit dem Versteilerungssignal verknüpften Nutzsignals einen bestimmten Wert oberhalb des Wertes des Nutzsignals nicht überschreitet. Dadurch wird vermieden, daß ein Überschwinger, der durch Verknüpfung mit dem Versteilerungssignal ins Nutzsignal eingebracht worden ist, bei hohen Nutzsignalamplituden beispielsweise zu Verzerrungen und damit zu neuen Störungen führt. Die Spannungsbegrenzung des Versteilerungssignals kann entweder unabhängig von der Amplitude des Nutzsignals oder nur beim Auftreten hoher Nutzsignalamplituden vorgenommen werden. Insbesondere beim Versteilern der Flanken eines Fernsehsignals wird dadurch auch unmittelbar im Bereich darzustellender Konturen eine Bildwiedergabe mit verminderten Störungen erhalten.

Einige Ausführungsbeispiele der Erfindung sind in der Zeichnung dargestellt und werden im nachfolgenden näher erläutert. Es zeigen
- Fig. 1: eine schematische Darstellung des erfindungsgemäßen Verfahrens,
- Fig. 2: das Blockschaltbild einer Schaltungsanordnung zur Durchführung des erfindungsgemäßen Verfahrens,
- Fig. 3: einige Signalverläufe der Schaltungsanordnung nach Fig. 2,
- Fig. 4: ein etwas detaillierter dargestelltes Ausführungsbeispiel einer Schaltungsanordnung nach der Erfindung und
- Fig. 5: eine Abwandlung bzw. detailliertere Darstellung der Schaltungsanordnung nach Fig. 4.
- Fig. 6: ein anderes Ausführungsbeispiel insbesondere für den Betrieb mit niedriger Versorgungsspannung,
- Fig. 7: ein Schaltungsdetail einer Abwandlung der Fig. 6.

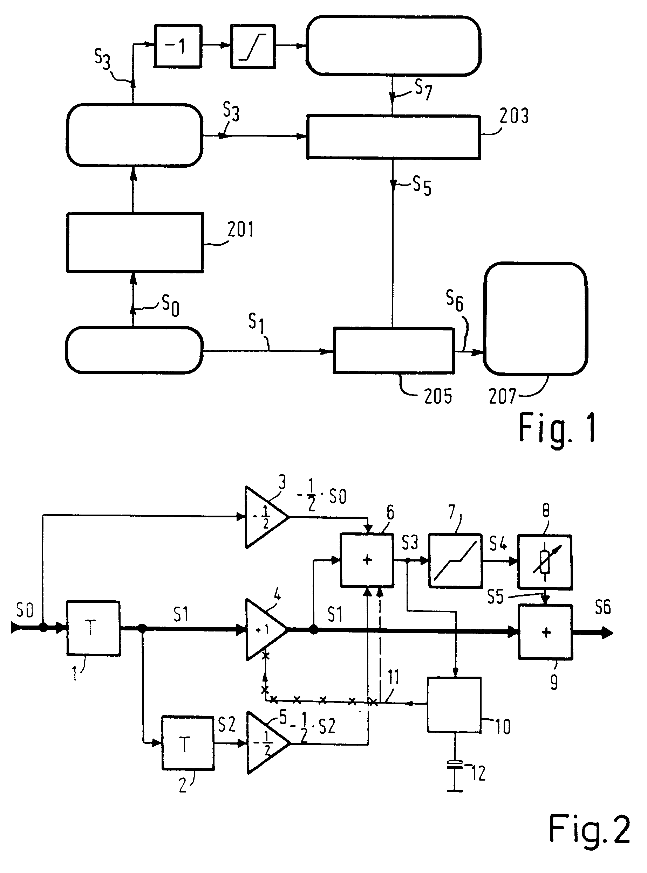

Das Flußdiagramm nach Fig. 1 zeigt eine schematische Übersicht über ein Verfahren zur Versteilerung der Flanken eines Nutzsignales. Dieses wird einer Versteilerungssignalstufe zugeführt, in der aus ihm ein Versteilerungssignal abgeleitet wird. Für diese Ableitung sind verschiedene Lösungen möglich. Beispielsweise kann in der Versteilerungssignalstufe zweimal der Differentialquotient des Nutzsignals über der Zeit gebildet werden, der im Bereich von Flanken einen höheren Betrag aufweist als im Bereich eines gleichförmigen Signalverlaufes. Eine andere Möglichkeit besteht darin, das Nutzsignal um verschiedene Zeitintervalle zu verzögern, und aus den unterschiedlich verzögerten Signalen und gegebenenfalls dem unverzögerten Nutzsignal eine Linearkombination zu bilden. In jedem Fall wird dabei ein Versteilerungssignal gewonnen, welches durch Verknüpfung, z. B. Addition oder Multiplikation, einen steileren Anstieg der Flanken des Nutzsignals bewirkt.

Erfindungsgemäß wird nun das Versteilerungssignal vor seiner Verknüpfung mit dem Nutzsignal in einem gesonderten Signalverarbeitungsschritt zunächst in seinem Vorzeichen umgekehrt, was durch eine Polaritätsumkehrstufe "-1" dargestellt ist. Anschließend wird das Signal in seiner Amplitude begrenzt, d. h. es werden alle Signalanteile unterdrückt, die eine vorgebbare Grenzamplitude überschreiten. Das so gewonnene Störunterdrückungssignal wird dem Versteilerungssignal überlagert, vorzugsweise additiv, und erst das so abgewandelte Versteilerungssignal wird mit dem Nutzsignal verknüpft.

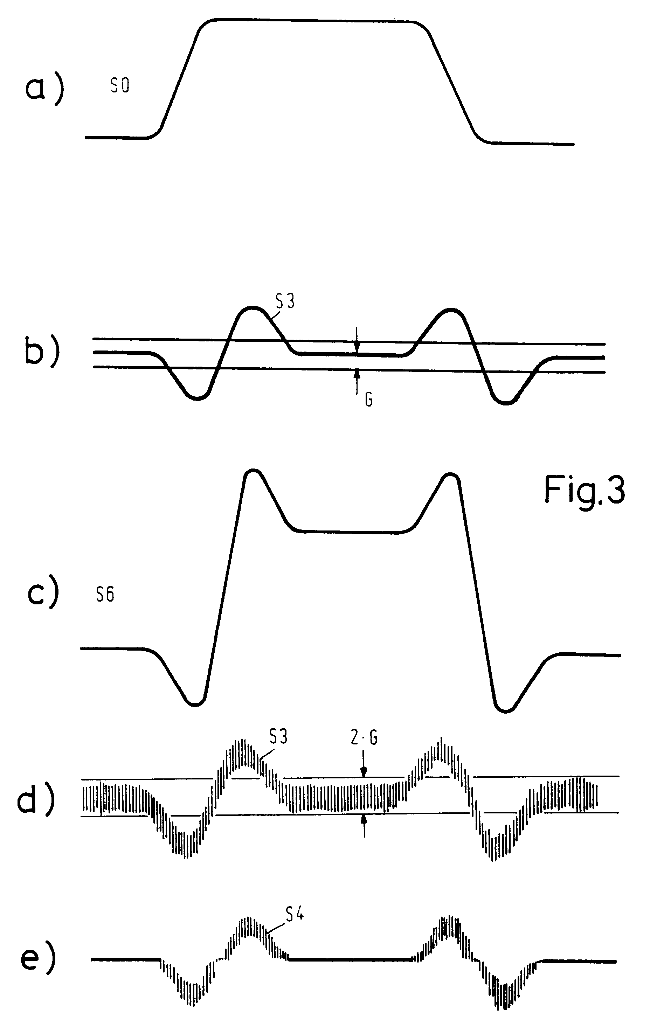

Fig. 2 zeigt ein Beispiel für eine Schaltungsanordnung, mit der eine derartige Signalverarbeitung vorgenommen werden kann, und Fig. 3 einige zugehörige Signalverläufe. Das Nutzsignal S0 wird in zwei Verzögerungsstufen 1 und 2 nacheinander um jeweils eine Verzögerungszeit T verzögert. Dabei entstehen die Signale S1 und S2.

Das Nutzsignal S0 und die verzögerten Nutzsignale S1 und S2 werden in Verstärkerstufen 3, 4 bzw. 5 um bestimmte Faktoren verstärkt, und zwar die Signale S0 und S2 um das (-1/2)-fache der Verstärkung für das Signal S1. Die so gewonnenen Signale werden in einer Addierstufe 6 summiert und ergeben das Versteilerungssignal S3. Dieses wird einer Störunterdrückungsstufe 7 zugeführt. Sie erzeugt aus dem Versteilerungssignal S3 durch Polaritätsumkehr und Begrenzung das Störunterdrückungssignal und überlagert es dem Versteilerungssignal S3. Das so gewonnene Signal S4 wird über eine Einstellstufe 8 geführt, in der seine Amplitude eingestellt wird, d.h. beispielsweise über einen Spannungsteiler, so daß sich daraus das amplitudenangepaßte, störungsarme Versteilerungssignal S5 ergibt.

Durch eine weitere Addierstufe 9 wird im letzten Schritt das einfach verzögerte Nutzsignal S1 mit dem störungsarmen Versteilerungssignal S5 zum Nutzsignal S6 mit versteilerten Flanken verknüpft.

Fig. 3 zeigt einige Signalverläufe der Schaltungsanordnung nach Fig. 2. Die Wirkungsweise der Versteilerung der Flanken des Nutzsignales ist an einem annähernd trapezförmigen Nutzsignal S0 gemäß Fig. 3a) erläutert, und zwar zunächst für den Fall eines störungsfreien Nutzsignales. Durch die in Fig. 2 dargestellte und aus den Verzögerungsstufen 1, 2, den Verstärkerstufen 3 bis 5 und der Addierstufe 6 bestehende Versteilerungssignalstufe wird aus dem (unverzögerten) Nutzsignal S0 das in Fig. 3b) wiedergegebene Versteilerungssignal S3 gebildet. Bei gleichförmigem Signalverlauf des Nutzsignales S0 verschwindet das Versteilerungssignal S3; nur im Bereich von Flanken im Nutzsignal S0 ist das Versteilerungssignal S3 von Null verschieden. Unter der Annahme, daß die Störunterdrückungsstufe 7 und die Einstellstufe 8 das Versteilerungssignal S3 unverändert passieren lassen, folgen die Signale S4 und S5 unmittelbar dem Verlauf von S3. Durch Überlagerung des Versteilerungssignals S3 mit dem verzögerten Nutzsignal S1 in der Addierstufe 9 ergibt sich das in Fig. 3c) wiedergegebene Nutzsignal S6 mit versteilerten Flanken. Durch Einstellen der Amplitude des Versteilerungssignales S5 in der Einstellstufe 8 können die im Nutzsignal S6 erkennbaren Überschwinger je nach Anforderungen in ihrer Höhe verändert werden, um zum Kompromiß zwischen Flankensteilheit und Intensität der Überschwinger zu gelangen.

Im Fall eines gestörten Nutzsignales S0, insbesondere durch hochfrequentes Rauschen, ist diesem ein Rauschsignal bestimmter Amplitude überlagert. Bei der Bildung des Versteilerungssignales S3 werden zwar im Bereich eines gleichförmigen Verlaufes des Nutzsignales S0 dessen Anteile, jedoch nicht die Anteile des Rauschsignales ausgelöscht. Damit erhält das Versteilerungssignal S3 einen in Fig. 3d) angedeuteten Verlauf. Würde nun das Signal S3 in dieser Form mit dem einfach verzögerten Nutzsignal S1 verknüpft, ergäbe das eine Summierung der Rauschanteile im Nutzsignal S6. Diese Rauschanteile würden sich noch stärker als im Nutzsignal S0, d. h. vor der Versteilerung der Flanken, insbesondere in Bereichen gleichförmigen Signalverlaufes störend bemerkbar machen.

Zur Unterdrückung dieses Rauschens wird nun in der Störunterdrückungsstufe 7 dem Versteilerungssignal gemäß Fig. 3d) das in seiner Polarität umgekehrte und auf die Grenzamplitude G begrenzte Versteilerungssignal überlagert. Das bedeutet, daß alle Signalaussschläge, die im Wertebereich von 2G um die Nullinie herum, d.h. um den Verlauf des störungsfreien Versteilerungssignales S3 nach Fig. 3b) im Bereich gleichförmiger Verläufe des Nutzsignales S0, liegen, ausgelöscht werden, und daß nur darüber hinausreichende Signalwerte von S3 im Versteilerungssignal S4 auftreten. Dies ist in Fig. 3e) dargestellt. Durch Verändern der Grenzamplitude G kann die Störunterdrückung der Amplitude des Rauschsignalanteils angepaßt werden. Wenn nun das störungsarme Versteilerungssignal S4, oder mit angepaßter Amplitude als S5, dem verzögerten Nutzsignal S1 überlagert wird, wird in den Bereichen gleichförmigen Verlaufes des Signales S1 kein zusätzliches Rauschen auftreten. Dieses ist lediglich im Bereich der Flanken des Nutzsignales S1 etwas erhöht, was jedoch beispielsweise in einem Videosignal als Nutzsignal S0 bzw. S6 kaum als störend empfunden wird.

Die Schaltungsanordnung nach Fig. 2 umfaßt weiterhin eine Arbeitspunkt-Regelstufe 10, die aus dem Versteilerungssignal S3 ein Regelsignal bildet und dieses zum Nachstellen des Arbeitspunktes der Verstärkerstufe 4 über eine Leitung 11 zuführt. Damit wird der Wert des Versteilerungssignales S3 über das Signal S1 im Bereich gleichförmigen Verlaufes des Nutzsignales S0, d.h. der Nullpunkt des Versteilerungssignales S3, derart nachgeregelt, daß er sich stets in der Mitte zwischen den durch die Grenzamplitude G vorgegebenen Werten befindet. Würde sich der Nullpunkt verschieben, wäre eine einwandfreie Störunterdrückung nicht mehr gewährleistet. Vorzugsweise bildet die Arbeitspunkt-Regelstufe 10 über einen Glättungskondensator 12 für die Erzeugung des Regelsignales den Mittelwert des Versteilerungssignales S3.

Das Regelsignal kann unter Berücksichtigung der Verstärkung und Signalpolarität auch den Verstärkerstufen 3 oder 5 zugeführt werden; entsprechend ist dann die Leitung 11 an eine dieser Verstärkerstufen zu führen. Eine weitere Möglichkeit besteht darin, das Regelsignal über die Leitung 11 unmittelbar der Addierstufe 6 zuzuleiten. Für diesen Fall ist in Fig. 2 die Leitung 11 gestrichelt gezeichnet, der durchgekreuzte Abschnitt der Leitung 11 wird dann aufgetrennt.

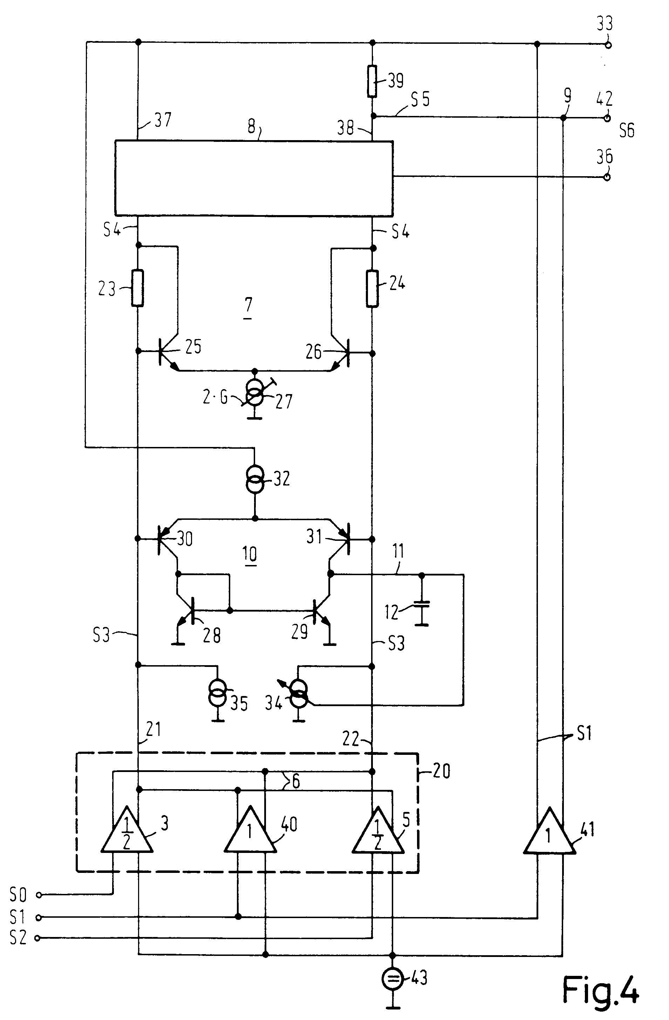

Fig. 4 zeigt ein detaillierteres Ausführungsbeispiel, in dem mit den vorherigen Figuren übereinstimmende Elemente wieder mit gleichen Bezugszeichen versehen sind. Die Verstärkerstufe 4 ist bei dem Beispiel nach Fig. 4 in zwei getrennte Verstärkerstufen 40 und 41 aufgeteilt worden, um das verzögerte Nutzsignal S1 voneinander entkoppelt den Addierstufen 6 bzw. 9 zuzuführen, die jeweils durch einfache galvanischen Verbindungen gebildet werden. Das Nutzsignal S0 und die daraus abgeleiteten Signale sind deshalb durch eingeprägte Ströme dargestellt. Die Verstärkerstufen 3, 40, 5 und die Addierstufe 6 bilden zusammen die gestrichelt umrandete Versteilerungssignalstufe 20, die das Versteilerungssignal S3 an zwei Gegentakt-Stromausgängen 21, 22 abgibt.

In der Anordnung nach Fig. 4 umfaßt die Störunterdrükkungsstufe 7 zwei Reihenwiderstände 23, 24, über die die Gegentakt-Stromausgänge 21 bzw. 22 mit niederohmigen Eingängen der Einstellstufe 8 verbunden sind. Jeder der Reihenwiderstände 23, 24 ist durch die Kollektor-Basis-Strecke eines von zwei Transistoren 25, 26 überbrückt, deren Emitteranschlüsse gemeinsam mit einem Anschluß einer Speisestromquelle 27 verbunden sind, während der andere Anschluß der Speisestromquelle an Masse liegt. Die Transistoren 25, 26 bilden somit einen emittergekoppelten Differenzverstärker, durch den der von der Speisestromquelle 27 gelieferte Strom in einer durch die Spannungen an den Basisanschlüssen der Transistoren 25, 26 bestimmten Aufteilung dem von den Gegentakt-Stromausgängen 21, 22 gelieferten Versteilerungssignal S3 überlagert wird. Diese Aufteilung wird durch die Spannungsabfälle an den Reihenwiderständen 23, 24 unmittelbar vom Versteilerungssignal derart bestimmt, daß die Kollektorströme der Transistoren 25, 26 die das Versteilerungssignal S3 bildenden Ströme kompensiert. In dem durch den Strom der Speisestromquelle 27 bestimmten Aussteuerungsbereich des Versteilerungssignales S3 verschwindet somit das Signal S4. Der Strom der Speisestromquelle 27 entspricht dem doppelten Wert der Grenzamplitude G. Wenn das Versteilerungssignal S3 verschwindet, sind die von den Gegentakt-Stromausgängen 21, 22 gelieferten Ströme und auch die Kollektorströme der Transistoren 25, 26 gleichgroß. Der Strom der Speisestromquelle 27 ist einstellbar, um die Grenzamplitude verändern zu können.

In der Regel ist die Grenzamplitude bedeutend kleiner als der größte Wert des Versteilerungssignals. Gegenüber diesem Wert geringe Abweichungen im Nullpunkt bzw. Arbeitspunkt der Versteilerungssignalstufe 20, d.h. in der Übereinstimmung der von den Gegentakt-Stromausgängen 21 bzw. 22 für den Fall eines verschwindenden Versteilerungssignales S3 gelieferten Ströme, haben daher eine verhältnismäßig große Asymmetrie der Lage dieses Nullpunktes bezüglich der Grenzamplituden zur Folge. Dem wird durch die Arbeitspunkt-Regelstufe 10 entgegengewirkt. Sie besteht in der Anordnung nach Fig. 4 aus einer gegen Masse geschalteten Stromspiegelanordnung aus zwei Stromspiegeltransistoren 28, 29, deren freie Anschlüsse - im vorliegenden Beispiel die Kollektoranschlüsse der bipolaren Transistoren - über ein emittergekoppeltes Transistorenpaar 30, 31 und eine daran angeschlossene Konstantstromquelle 32 mit einem Versorgungsspannungsanschluß 33 verbunden sind. Der Strom der Konstantstromquelle 32 wird in zwei den Spannungen an den Gegentakt-Stromausgängen 21 und 22 entsprechende Anteile aufgeteilt, die durch die Transistoren 30, 28 einerseits und 31 andererseits fließen. Außerdem wird der Strom im Transistor 30 durch die Stromspiegelanordnung 28, 29 in den Stromspiegeltransistor 29 "gespiegelt", so daß auf der an den Verbindungspunkt zwischen dem Transistor 31 und dem Stromspiegeltransistor 29 angeschlossenen Leitung 11 ein Signal auftritt, das der Differenz der Anteile der Ströme der Konstantstromquelle 32 entspricht. Dieses wird durch den Glättungskondensator 12 von Videosignalanteilen befreit und als Regelsignal einer einstellbaren Arbeitspunkt-Stromquelle 34 zugeführt, die gemeinsam mit einer weiteren Arbeitspunkt-Stromquelle 35 den Nullpunkt des Versteilerungssignales bestimmt.

Zur Einstellung der Amplitude des störungsarmen Versteilerungssignales S4 in der Einstellstufe 8 wird dieser über einen Einstelleingang 36 ein Einstellsignal zugeleitet. Das amplitudenangepaßte Versteilerungssignal S5 wird von der Einstellstufe 8 ebenfalls über Gegentakt-Stromausgänge 37, 38 abgegeben,von denen einer unmittelbar und der andere über einen Arbeitswiderstand 39 mit dem Versorgungsspannungsanschluß 33 verbunden ist. Das Signal S5 vom Gegentakt-Stromausgang 38 wird an dem die Addierstufe 9 bildenden Verbindungspunkt mit einem der Ausgänge der Verstärkerstufe 41 mit dem verzögerten Nutzsignal S1 verknüpft und als Nutzsignal S6 mit versteilerten Flanken am Ausgang 42 abgegeben. Die Verstärkerstufen 3, 40, 5, 41 sind im vorliegenden Beispiel als Differenzverstärkerstufen ausgeführt, denen an je einem Referenzeingang eine Referenzspannung von einer Referenzspannungsquelle 43 zugeleitet wird.

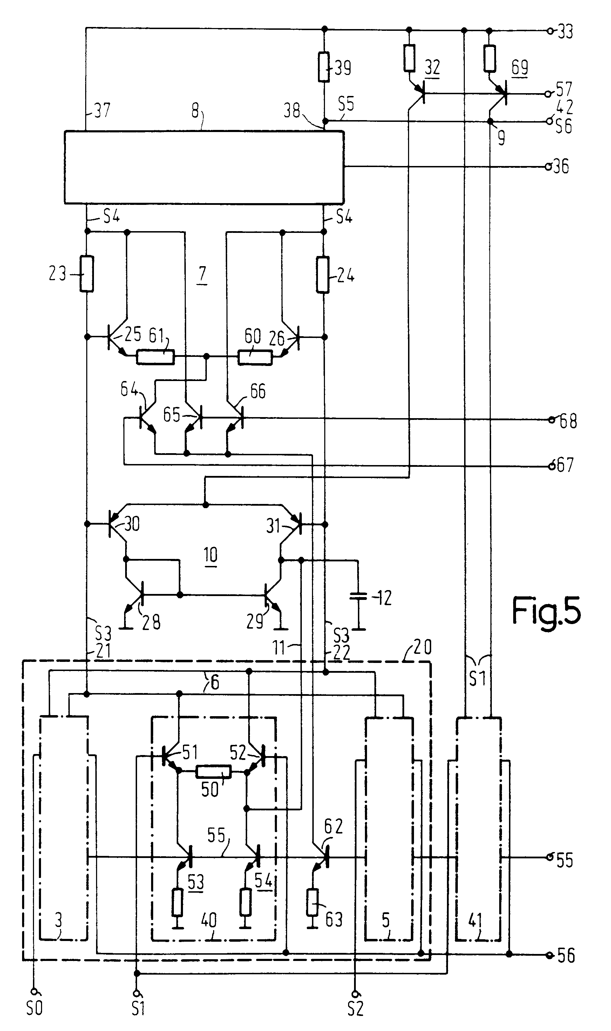

Fig. 5 zeigt die Anordnung nach Fig. 4 in etwas detaillierterer Darstellung. Die Verstärkerstufe 40 umfaßt ein über einen Widerstand gegengekoppeltes Paar aus zwei Differenzverstärker-Transistoren 51, 52, deren Emitteranschlüsse durch aus je einem Stromquellentransistor und einem Stromquellenwiderstand bestehende Stromquellen 53 bzw. 54 gespeist werden. Die Stromquellentransistoren werden über ihre Steueranschlüsse von einem gemeinsamen Referenzspannungsanschluß 55 gesteuert. Die übrigen Verstärkerstufen 3, 5, 41 sind entsprechend aufgebaut und alle mit dem Referenzspannungsanschluß 55 verbunden. Der Steueranschluß des Differenzverstärker-Transistors 52 und der entsprechenden Transistoren in den Verstärkerstufen 3, 5, 41 ist an einen weiteren Referenzspannungsanschluß 56 geführt.

In der Störunterdrückungsstufe 7 sind in die Verbindung der Emitteranschlüsse der Transistoren 25 und 26 zwei Emitterwiderstände 60, 61 eingefügt worden, mit deren Dimensionierung der Spannungsaussteuerungsbereich an den Steueranschlüssen der Transistoren 25, 26 bestimmt werden kann. Die Speisestromquelle 27 wird durch einen an den Referenzspannungsanschluß 55 angeschlossenen Stromquellentransistor 62 mit zugehörigem Stromquellenwiderstand 63 sowie einen dazu in Reihe angeordneten Einstelltransistor 64 gebildet, zu dem sowie zu den Emitterwiderständen 60 bzw. 61 und den Hauptstrompfaden der Transistoren 25 bzw. 26 parallel zwei Arbeitspunkt-Einstelltransistoren 65, 66 angeordnet sind. Durch entsprechend gewählte Spannungen an den Steuereingängen 67, 68 der Einstelltransistoren 64 bis 66 wird der Strom der Speisestromquelle, d.h. vom Stromquellentransistor 62, in zwei feste Anteile über die Arbeitspunkt-Einstelltransistoren 65 und 66 und einen weiteren Anteil über den Einstelltransistor 64 aufgeteilt. Der Strom über den Einstelltransistor 64 bestimmt in der beschriebenen Weise die Grenzamplitude. Diese Anordnung gewährleistet, daß auch bei Veränderung der Grenzamplitude der Arbeitspunkt beispielsweise der Einstellstufe 8 unverändert bleibt.

In ähnlicher Weise wie die Stromquellen 53, 54 und 62, 63 ist auch die Konstantstromquelle 32 ausgebildet, jedoch mit einem PNP-Transistor anstelle eines NPN-Transistors und ist mit dem Versorgungsspannungsanschluß 33 verbunden. Der Strom der Konstantstromquelle 32 wird über einen dritten Referenzspannungsanschluß 57 bestimmt, an den auch eine die Verstärkerstufe 41 speisende, entsprechend aufgebaute Stromquelle 69 angeschlossen ist. Die Referenzspannungsanschlüsse 55, 56, 57 werden bevorzugt aus einer gemeinsamen, nicht dargestellten Referenzspannungsquelle gespeist, die mehrere in gleicher Weise stabilisierte Referenzspannungen liefert.

Von der Arbeitspunkt-Regelstufe 10 wird bei der Anordnung nach Fig. 5 ein Zusatzgleichstrom über die Leitung 11 direkt in den Emitteranschluß des Differenzverstärker-Transitors 52 der Verstärkerstufe 40 eingespeist. Er beeinflußt von dort unmittelbar den den Nullpunkt des Versteilerungssignales S3 bestimmenden Gleichstrom im Gegentakt-Stromausgang 22. Durch diese Schaltung kann eine gesonderte Arbeitspunkt-Stromquelle 34 entfallen. Entsprechend wird der Strom der Arbeitspunkt-Stromquelle 35 aus Fig. 4 durch die Stromquelle 53 geliefert. Dazu sind die Stromquellenwiderstände der Stromquellen 53 und 54 unterschiedlich dimensioniert. Bei der Anordnung nach Fig. 5 bilden die Konstantstromquelle 32 sowie die Transistoren 28 bis 31 und der Glättungskondensator 12 zusammen eine Zusatzstromquelle.

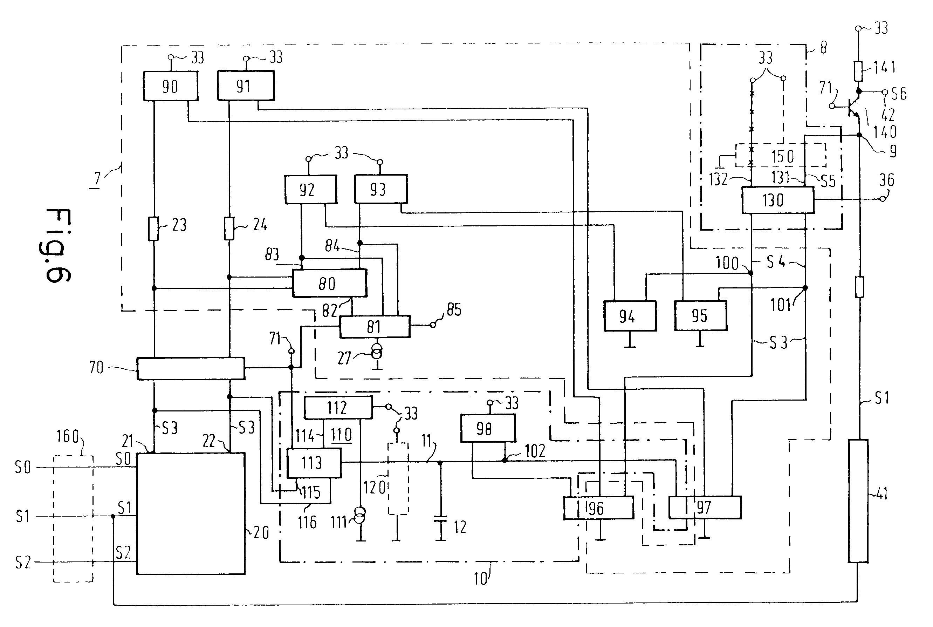

Fig. 6 zeigt ein anderes Ausführungsbeispiel mit einer Schaltungsanordnung, die für den Betrieb mit einer niedrigen Versorgungsspannung ausgelegt ist und in der mit den vorherigen Figuren übereinstimmende Elemente wieder mit gleichen Bezugszeichen versehen und blockschaltbildartig wiedergegeben sind. So entspricht der innere Aufbau der Versteilerungssignalstufe 20 beispielsweise dem nach Fig. 5, wobei das Versteilerungssignal S3 wieder an den Gegentakt-Stromausgängen 21, 22 abgegeben wird.

In Fig. 6 wird das Versteilerungssignal S3 ausgehend von der Versteilerungssignalstufe 20 über einen Trennverstärker 70 den Reihenwiderständen 23, 24 zugeleitet. Der Trennverstärker 70 umfaßt vorzugsweise für jeden der Gegentakt-Stromausgänge 21, 22 einen Transistor, dessen Hauptstrompfad in Reihe zwischen den zugehörigen Gegentakt-Stromausgang 21 bzw. 22 und den Reihenwiderstand 23 bzw. 24 geschaltet und dessen Steueranschluß an eine gemeinsame Referenzspannungsleitung 71 angeschlossen ist. Der Trennverstärker 70 dient im wesentlichen zur Entkopplung der durch den Aufbau der Versteilerungssignalstufe 20 bedingten parasitären Kapazitäten an den Gegentakt-Stromausgängen 21 und 22 von den Reihenwiderständen 23 und 24, so daß ein durch das Zusammenwirken dieser Elemente mögliches parasitäres Tiefpaßverhalten der Schaltungsanordnung verhindert wird. Die das Versteilerungssignal S3 bildenden Ströme werden dadurch nicht verändert.

Die Störunterdrückungsstufe 7 umfaßt wieder einen emittergekoppelten Differenzverstärker 80, der wie in Fig. 5 zwei Transistoren und gegebenenfalls zwei Emitterwiderstände umfaßt. Den als Steueranschlüsse dienenden Basisanschlüssen der Transistoren werden die dem Versteilerungssignal entsprechenden Spannungen an den Verbindungspunkten der Reihenwiderstände 23 bzw. 24 mit dem Trennverstärker 70 zugeführt. Von der Speisestromquelle 27 wird ein Strom über eine Einstellanordnung 81 geführt und dort in drei Anteile aufgeteilt. Die Einstellanordnung 81 entspricht vorzugsweise der Anordnung aus Einstelltransistor 64 und Arbeitspunkt-Einstelltransistoren 65, 66 gemäß Fig. 5. Mit dem ersten der Stromanteile wird der emittergekoppelte Differenzverstärker 80 am Eingang 82 gespeist, während die beiden übrigen, einander gleichen Stromanteile über zwei weitere Leitungen an die Ausgänge 83 bzw. 84 des emittergekoppelten Differenzverstärkers 80 geführt werden. Zur Arbeitspunkteinstellung ist die Einstellanordnung 81 mit der Referenzspannungsleitung 71 verbunden. Über einen Schalteingang 85 kann der über den emittergekoppelten Differenzverstärker 80 geleitete Stromanteil aus der Speisestromquelle 27 verändert bzw. völlig abgeschaltet werden, wobei die Summe der von der Einstellanordnung 81 abgegebenen Ströme stets konstant bleibt, um den Arbeitspunkt der gesamten Schaltungsanordnung nicht zu verschieben.

Das Störunterdrückungssignal von den Ausgängen 83, 84 wird zweimal über je zwei paarweise angeordnete Stromspiegelanordnungen 92, 93 und 94, 95 gespiegelt und das Versteilerungssignal S3 von den dem Trennverstärker 70 abgewandten Anschlüssen der Reihenwiderstände 23, 24 wird entsprechend über zweimal zwei paarweise angeordnete Stromspiegelanordnungen 90, 91 und 96, 97 gespiegelt. Anschließend werden die durch Ströme gebildeten Signale in zwei Leitungsknotenpunkten 100, 101 einander zum Signal S4 überlagert.

Im Vergleich zu den Schaltungsanordnungen nach Fig. 4 und 5 ist das vorliegende Ausführungsbeispiel für den Betrieb mit einer niedrigen Versorgungsspannung, beispielsweise im Bereich von 5 bis 8 Volt, geeignet. Dazu wird mit Hilfe der Stromspiegelanordnungen 90 bis 97 die Anzahl der zwischen dem Versorgungsspannungsanschluß 33 und Masse in Reihe geschalteten Baugruppen niedrig gehalten, so daß trotz der niedrigen Versorgungsspannung die erforderlichen Gleichspannungspegel bzw. Signalspannungshübe gewährleistet sind.

Die Stromspiegelanordnungen 90 bis 95 sind in üblicher Weise mit zwei Stromzweigen aufgebaut, beispielsweise gemäß RCA Technical Notes Nr. 949 vom 31.12.1973. Für die Stromspiegelanordnungen 90 bis 93 werden insbesondere die dazu komplementären Anordnungen mit PNP-Transistoren eingesetzt. Die Stromspiegelanordnungen 96 und 97 weichen in ihrer Bauart von den übrigen Stromspiegelanordnungen ab und sind bevorzugt gemäß Fig. 9 der RCA Technical Notes Nr. 949 gestaltet.

Aus den gegenüber den Stromspiegelanordnungen 90 bis 95 zusätzlichen Ausgängen der Stromspiegelanordnungen 96, 97 werden den das Versteilerungssignal S3 bildenden Strömen in den Reihenwiderständen 23, 24 entsprechende Signalströme abgeleitet. Der Signalstrom aus der Stromspiegelanordnung 96 wird über eine weitere Stromspiegelanordnung 98 "gespiegelt" und in einem mit der Leitung 11 verbundenen Knotenpunkt 102 dem Signalstrom aus der Stromspiegelanordnung 97 subtraktiv überlagert. Auf der Leitung 11 tritt damit ein der Differenz der Ströme aus den Stromspiegelanordnungen 96, 97 entsprechendes Signal auf. Die Summe der aus den Stromspiegelanordnungen 96, 97 entnommenen Signalströme, die wegen der gegenläufigen Steuerung durch die das Versteilerungssignal S3 bildenden Ströme konstant ist, übernimmt im vorliegenden Ausführungsbeispiel die Rolle des Stromes der Konstantstromquelle 32 nach Fig. 4.

Im Glättungskondensator 12 werden aus dem Regelsignal auf der Leitung 11 Versteilerungssignalanteile herausgesiebt und das dermaßen geglättete Regelsignal einer einstellbaren Arbeitspunkt-Stromquelle 110 zugeführt. Diese umfaßt eine Konstantstromquelle 111, deren Strom über eine Stromspiegelanordnung 112 "gespiegelt" und als Speisestrom einem emittergekoppelten Differenzverstärker 113 an dessen gemeinsamem Emitteranschluß 114 zugeleitet wird. Im Differenzverstärker 113 wird der Strom aus der Konstantstromquelle 111 nach Maßgabe der Spannungsdifferenz zwischen der Referenzspannungsleitung 71 und der das Regelsignal repräsentierenden Spannung auf der Leitung 11 auf zwei Ausgänge 115, 116 verteilt, die mit den Gegentakt-Stromausgängen 21, 22 verbunden sind. Da die Summe der Regelströme an den Ausgängen 115, 116 konstant ist, wird durch die Regelung für den Arbeitspunkt des Versteilerungssignals S3 dessen Gleichstrompegel und damit auch der Gleichspannungspegel unverändert bleiben. Dadurch werden Gleichspannungsverschiebungen in Abhängigkeit von der Regelung vermieden, die sich ungünstig auf die Spannungspegel und Spannungshübe insbesondere im Hinblick auf die niedrige Versorgungsspannung auswirken würden.

In die Leitung 11 kann wahlweise eine Spannungsbegrenzungsschaltung 120 eingefügt werden, um die dem Differenzverstärker 113 vom Glättungskondensator 12 zugeführte Spannung auf einen Bereich zu begrenzen, der für deren vollständige Aussteuerung ausreichend ist. Dadurch werden einerseits übermäßig starke Umladungen des Glättungskondensators 12 durch Signalstörungen vermieden und wird andererseits der Differenzverstärker 113 vor Überlastung geschützt.

Der emittergekoppelte Differenzverstärker 113 ist bevorzugt mit einer Gegenkopplung ausgeführt, durch die sein Verstärkungsgrad derart herabgesetzt ist, daß durch ihn kein merkliches zusätzliches Rauschen in das Versteilerungssignal eingebracht wird, was anderenfalls die Effektivität der Störunterdrückung vermindern würde. Der Verstärkungsgrad des emittergekoppelten Differenzverstärkers 113 wird nur gerade so groß gewählt, daß die durch ihn beeinflußte Regelsteilheit der Arbeitspunktregelung einen hinreichend niedrigen Regelfehler gewährleistet. Dagegen ist eine schnelle Nachregelung des Arbeitspunktes nicht erforderlich.

Von den Leitungsknotenpunkten 100, 101 wird das mit dem Störunterdrückungssignal überlagerte Versteilerungssignal S4 in der Einstellstufe 8 über eine Potentiometerschaltung 130 geführt und in bereits beschriebener Weise an dem die weitere Addierstufe 9 bildenden Knotenpunkt mit dem Nutzsignal S1 verknüpft. Die Potentiometerschaltung 130 besteht in an sich bekannter Weise aus zwei emittergekoppelten Transistorenpaaren, deren Steueranschlüsse über Kreuz miteinander verbunden sind und den Einstelleingang 36 für das Einstellsignal der Amplitude des Versteilerungssignals S3 bzw. S4 bilden. Die ebenfalls über Kreuz gekoppelten Kollektoranschlüsse der Transistorenpaare bilden Ausgänge 131, 132 der Potentiometerschaltung 130. Während am Ausgang 131 das amplitudenangepaßte, störungsarme Versteilerungssignal S5 abgegeben wird, ist der Ausgang 132 mit dem Versorgungsspannungsanschluß 33 verbunden.

Von dem die weitere Addierstufe 9 bildenden Knotenpunkt wird das Nutzsignal S6 mit versteilerten Flanken über eine Auskoppelschaltung geführt, die aus einem Transistor 140 und einem zu seinem Hauptstrompfad in Reihe geschalteten Kollektorwiderstand 141 besteht. Der Emitteranschluß des Transistors 140 ist mit dem Knotenpunkt 9, der Ausgang 42 mit dem Kollektoranschluß des Transistors 140 verbunden. Dem Steueranschluß des Transistors 140 wird die Spannung der Referenzspannungsleitung 71 zugeführt. Der Transistor 140 dient im wesentlichen zur Entkopplung parasitärer Kapazitäten vom Weg des Nutzsignals S6.

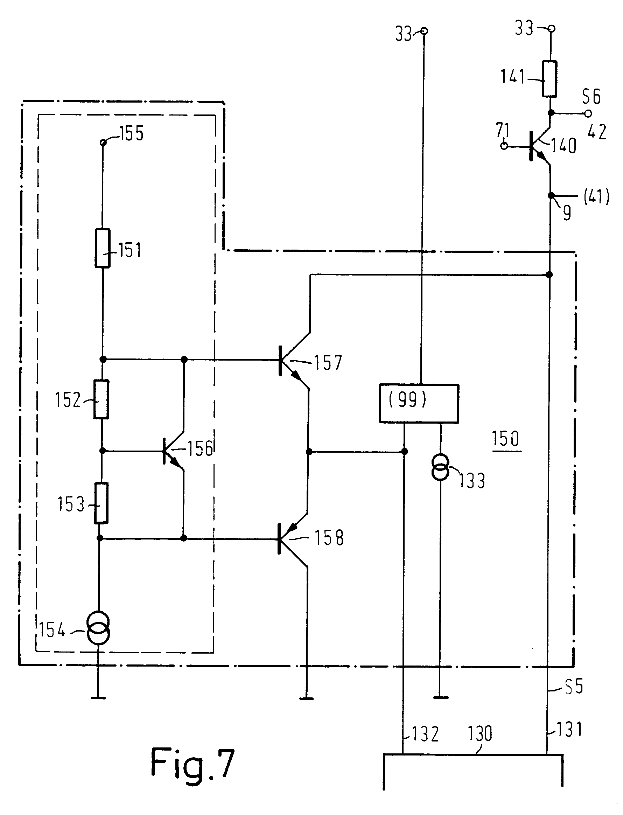

Die Potentiometerschaltung 130 kann an ihren Ausgängen 131, 132 vorteilhaft mit einer weiteren Spannungsbegrenzungsschaltung 150 verbunden sein, für die ein detailliertes Ausführungsbeispiel in Figur 7 wiedergegeben ist. Sie umfaßt einen Spannungsteiler aus drei Widerständen 151, 152 und 153 sowie einer Stromquelle 154, die alle in Reihenschaltung zwischen einem Referenzspannungsanschluß 155 und Masse angeordnet sind. Ein Transistor 156 überbrückt mit seiner Kollektor-Basis-Strecke den Widerstand 152 und mit seiner Basis-Emitter-Strecke den Widerstand 153. Mit dem Kollektor- und dem Emitteranschluß des Transistors 156 sind die Basisanschlüsse zweier Überschußstromtransistoren 157, 158 verbunden. Eine derartige Anordnung ist bereits in der deutschen Patentanmeldung P 36 42 618.0, insbesondere Fig. 12 mit zugehörigem Text, beschrieben. Die Überschußstromtransistoren 157, 158 sind komplementär zueinander und mit ihren Emitteranschlüssen mit der Verbindung zwischen dem Ausgang 132 und dem Ausgang einer Stromspiegelanordnung 99 verbunden. Der Kollektoranschluß des Überschußstromtransistors 158 ist an Masse, derjenige des anderen Überschußstromtransistors 157 an den Knotenpunkt 9 gelegt. Dabei bleibt die Verbindung zwischen dem Ausgang 131 und der weiteren Addierstufe 9 (Knotenpunkt) bei der Abwandlung nach Fig. 7 gegenüber der Anordnung nach Fig. 6 unverändert.

Dagegen ist der Ausgang 132 in Fig. 7 mit dem Versorgungsspannungsanschluß 33 über die Stromspiegelanordnung 99 verbunden, die in die Verbindung zwischen ihrem Ausgang, den Überschußtransistoren 157, 158 und dem Ausgang 132 den Strom einer Stromquelle 133 einspeist.

Der Spannungsbereich des Nutzsignals S6 am Ausgang 42 wird durch den Widerstandswert des Kollektorwiderstands 141 und den Stromaussteuerbereich der Ausgänge 131, 132 bestimmt. Bei einem niedrigen Strom am Ausgang 131 tritt am Kollektorwiderstand 141 eine hohe Spannung auf, so daß das Nutzsignal S6 einen niedrigen Spannungswert annimmt. Zugleich fließt am Ausgang 132 ein niedriger Strom, der von der Stromquelle 133 über die Stromspiegelanordnung 99 geliefert wird. Der Strom der Stromquelle 133 ist jedoch so groß bemessen, daß er in diesem Fall größer ist als der in den Ausgang 132 eingespeiste Strom. Der überschüssige Strom fließt über den Überschußstromtransistor 158 nach Masse ab.

Bei einem geringen Strom am Ausgang 131 nimmt dagegen das Nutzsignal S6 am Ausgang 42 einen hohen Spannungswert an. Zugleich fließt am Ausgang 132 ein hoher Strom, der größer ist als der von der Stromquelle 133 nachgelieferte Strom. Über den Überschußstromtransistor 157 wird dann ein Strom zum Ausgleich der Stromsumme an der Verbindung zwischen dem Ausgang 132, dem Stromspiegel 99 und den Überschußstromtransistoren 157, 158 nachgeliefert, der ebenfalls über den Kollektorwiderstand 141 und den Transistor 140 fließt und somit den Spannungswert des Nutzsignals S6 vermindert. Durch Wahl des Stromes der Stromquelle 133 wird der Aussteuerungsbereich des Versteilerungssignals S5 am Ausgang 131 gewählt, in dem die beschriebene Spannungsbegrenzung des Nutzsignals S6 wirksam sein soll.

Der Versteilerungssignalstufe 20 ist vorteilhaft eine Emitterfolgerstufe 160 vorgeschaltet, wie dies in Fig. 6 angedeutet ist. Dadurch wird in an sich bekannter Weise eine verbesserte Signalentkopplung von vorausgehenden Signalbearbeitungsstufen erhalten.

Die vorstehend beschriebenen Schaltungsteile sind bevorzugt auf einem Halbleiterkristall in einer integrierten Schaltungsanordnung zusammengefaßt, von der lediglich der Glättungskondensator 12 seiner Größe wegen ausgenommen ist. Die Speisestromquelle 27, die Konstantstromquelle 111, die Stromquellen 133, 154 sowie die Versteilerungssignalstufe 20, die Verstärkerstufe 41 und die Emitterfolgerstufe 160 sind dabei vorzugsweise mit einer gemeinsamen Spannungsreferenz verbunden, die alle darin auftretenden Konstantströme und -spannungen bestimmt. Zusammen mit der Integration auf einem Halbleiterkristall werden dann im Zusammenhang mit den Widerstandstoleranzen bei der Fertigung, die mit Änderungen der Referenzen durch Fertigungsstreuungen gleichmäßig korrespondieren, insgesamt sehr geringe Fehler möglich.

## Patentansprüche

1. Schaltungsanordnung zum Vermindern von Störungen beim Versteilern der Flanken eines Nutzsignales durch Verknüpfung mit einem daraus abgeleiteten Versteilerungssignal, das nur bei Überschreiten einer vorgegebenen Grenzamplitude das Nutzsignal beeinflußt, mit einer Versteilerungssignalstufe (20) zum Liefern des Versteilerungssignales und einer Störunterdrückungsstufe (7), in der ein Störunterdrückungssignal erzeugt und dem Versteilerungssignal überlagert wird, wobei die Versteilerungssignalstufe das Versteilerungssignal an zwei Gegentakt-Stromausgängen abgibt,
dadurch gekennzeichnet, daß von den Gegentakt-Stromausgängen (21, 22) in der Störunterdrückungsstufe (7) jeder mit einem Reihenwiderstand (23, 24) sowie dem Steueranschluß eines von zwei Transistoren (25, 26) verbunden ist, deren Hauptstrompfade an ihrem einen Ende miteinander an eine Speisestromquelle (27) angeschlossen und an ihrem anderen Ende mit dem vom Gegentakt-Stromausgang (21 bzw. 22) abgewandten Anschluß des zugehörigen Reihenwiderstandes (23, 24) verbunden sind.

2. Schaltungsanordnung nach Anspruch 1,
dadurch gekennzeichnet, daß der Strom der Speisestromquelle (27) einstellbar ist.

3. Schaltungsanordnung nach Anspruch 1 oder 2,
gekennzeichnet durch eine Arbeitspunkt-Regelstufe (10), die aus einem Vergleich zweier aus den Gegentakt-Stromausgängen (21, 22) abgeleiteter Spannungen einen Zusatzgleichstrom (auf 11) zum Nachregeln des Gleichstromes wenigstens in einem der Gegentakt-Stromausgänge (22) bildet.

4. Schaltungsanordnung nach Anspruch 3,
dadurch gekennzeichnet, daß die Gleichströme in den Gegentakt-Stromausgängen (21, 22) vom Zusatzgleichstrom (auf 11) gegenläufig nachgeregelt werden.

5. Schaltungsanordnung nach Anspruch 3 oder 4,
gekennzeichnet durch eine Konstantstromquelle (32), deren Strom in zwei den aus den Gegentakt-Stromausgängen (21, 22) abgeleiteten Spannungen entsprechende Anteile aufgeteilt wird, wobei der Zusatzgleichstrom (auf 11) der Differenz dieser Anteile entspricht.

6. Schaltungsanordnung nach Anspruch 3, 4 oder 5,
dadurch gekennzeichnet, daß der Zusatzgleichstrom (auf 11) in die Versteilerungssignalstufe (20) eingespeist wird.

7. Schaltungsanordnung nach einem der Ansprüche 1 bis 6,
dadurch gekennzeichnet, daß das Versteilerungssignal (S3) und/oder das Störunterdrückungssignal vor dem Überlagern über wenigstens eine Stromspiegelanordnung geführt werden.

8. Schaltungsanordnung nach Anspruch 7,
dadurch gekennzeichnet, daß wenigstens eine der Stromspiegelanordnungen im Signalweg des Versteilerungssignals (S3) zwischen den von den Gegenstakt-Stromausgängen (21, 22) abgewandten Anschlüssen der Reihenwiderstände (23,24) und einem Schaltungspunkt für das Überlagern des Störunterdrückungssignals angeordnet ist.

9. Schaltungsanordnung nach einem der Ansprüche 1 bis 8,
gekennzeichnet durch eine Spannungsbegrenzungsstufe, die das mit dem Störunterdrückungssignal überlagerte Versteilerungssignal (S3) in der dem Nutzsignal (S1) gleichgerichteten Polarität derart begrenzt, daß die Amplitude des mit dem Versteilerungssignal verknüpften Nutzsignals (S6) einen bestimmten Wert oberhalb des Wertes des Nutzsignals (S1) nicht überschreitet.

## Claims

1. A circuit arrangement for reducing noise when peaking the edges of a useful signal by combination with a peaking signal derived therefrom, which signal only influences the useful signal when a predetermined amplitude threshold is exceeded, said arrangement comprising a peaking signal stage (20) for supplying the peaking signal and a noise suppression stage (7) in which a noise suppression signal is generated and is superimposed on the peaking signal, the peaking signal stage applying the peaking signal to two push-pull curtent outputs, characterized in that each of the push-pull current outputs (21, 22) in the noise suppression stage (7) is connected to a series resistor (23, 24) and to the control terminal of one of two transistors (25, 26) whose main current paths at one end are connected together and to a supply current source (27) and at the other end are connected to the terminal of the associated series resistor (23, 24) remote from the push-pull current output (21, 22, respectively).

2. A circuit arrangement as claimed in Claim 1, characterized in that the current of the supply current source (27) is adjustable.

3. A circuit arrangement as claimed in Claim 1 or 2, characterized by a working point control stage (10) which forms an additional direct current (at 11) for re-adjusting the direct current in at least one of the push-pull current outputs (22) from a comparison of two voltages derived from the push-pull current outputs (21, 22).

4. A circuit arrangement as claimed in Claim 3, characterized in that the direct currents in the push-pull current outputs (21, 22) are re-adjusted in opposite directions by the additional direct current (at 11).

5. A circuit arrangement as claimed in Claim 3 or 4, characterized by a constant current source (32) whose current is split up into two components corresponding to the voltages derived from the push-pull current outputs (21, 22), whilst the additional direct current (at 11) corresponds to the difference hetween said components.

6. A circuit arrangement as claimed in Claim 3, 4 or 5, characterized in that the additional direct current (at 11) is supplied to the peaking signal stage (20).

7. A circuit arrangement as claimed in any one of Claims 1 to 6, characterized in that the peaking signal (S3) and/or the noise suppression signal are applied via at least one current mirror circuit before they are superimposed.

8. A circuit arrangement as claimed in Claim 7, characterized in that at least one of the current mirror circuits in the signal path of the peaking signal (S3) is arranged between the terminals of the series resistors (23, 24) remote from the push-pull current outputs (21, 22) and a circuit point for superimposing the noise suppression signal.

9. A circuit arrangement as claimed in any one of Claims 1 to 8, characterized by a voltage limiter stage which limits the peaking signal (S3) superimposed on the noise suppression signal in the polarity having the same direction as that of the useful signal (S1), such that the amplitude of the useful signal (S6) combined with the peaking signal does not exceed a given value above the value of the useful signal (S1).

## Revendications

1. Montage de circuit permettant de diminuer les parasites qui résultent d'une augmentation de la raideur des flancs d'un signal utile par combinaison avec un signal d'augmentation de raideur qui en dérive et qui n'influence le signal utile qu'en cas de dépassement d'une amplitude limite prédéterminée, ce montage de circuit comportant un étage de signaux d'augmentation de raideur (20) destiné à délivrer le signal d'augmentation de raideur et un étage de suppression des parasites (7), dans lequel un signal de suppression des parasites est formé et superposé au signal d'augmentation de raideur, l'étage de signal d'augmentation de raideur délivrant le signal d'augmentation de raideur à deux sorties de courant symétriques, caractérisé en ce que dans l'étage de suppression de parasites (7), chacune des sorties de courant symétriques (21, 22) est couplée à une résistance en série (23, 24) ainsi qu'à une borne de commande de l'un de deux transistors (25, 26) dont les voies de courant principales sont couplées à une des extrémités des voies de courant principales, l'une à l'autre et à une source de courant d'alimentation (27) et, à l'autre extrémité des voies de courant principales, à la borne de la résistance en série (23, 24) correspondante, quelle borne est opposée à la sortie de courant symétrique (21 ou 22) correspondante.

2. Montage de circuit selon la revendication 1, caractérisé en ce que le courant de la source de courant d'alimentation (27) est réglable.

3. Montage de circuit selon la revendication 1 ou 2, caractérisé par un étage de réglage du point de fonctionnement (10) qui forme un courant continu auxiliaire (en 11) pour le réajustement du courant continu dans au moins une des sorties de courant symétriques (22), à partir d'une comparaison de deux tensions dérivées des sorties de courant symétriques (21, 22).

4. Montage de circuit selon la revendication 3, caractérisé en ce que les courants continus aux sorties de courant symétriques (21, 22) sont rajustés en sens opposés par le courant continu auxiliaire (en 11).

5. Montage de circuit selon la revendication 3 ou 4, caractérisé par une source de courant constant (32), dont le courant est réparti en deux fractions correspondant aux tensions dérivées des sorties de courant symétriques (21, 22), le courant continu auxiliaire (en 11) correspondant à la différence de ces fractions.

6. Montage de circuit selon la revendication 3, 4 ou 5, caractérisé en ce que le courant continu auxiliaire (en 11) est acheminé dans l'étage de signaux d'augmentation de raideur (20).

7. Montage de circuit selon l'une quelconque des revendications 1 à 6, caractérisé en ce que le signal d'augmentation de raideur (S3) et/ou le signal de suppression de parasites sont acheminés avant leur superposition via au moins un miroir de courant.

8. Montage de circuit selon la revendication 7, caractérisé en ce qu'au moins un des miroirs de courant dans la voie d'acheminement du signal d'augmentation de raideur (S3) est disposé entre les bornes des résistances en série (23, 24) opposées aux sorties de courant symétriques (21, 22) et un point de circuit pour la superposition du signal de suppression de parasites.

9. Montage de circuit selon l'une quelconque des revendications 1 à 8, caractérisé par un étage limiteur de tension, qui limite le signal d'augmentation de raideur (S3) auquel le signal de suppression de parasites est superposé, en polarité de même sens que le signal utile (S1), de telle sorte que l'amplitude du signal utile (S6) combiné au signal d'augmentation de raideur ne dépasse pas une valeur déterminée située au-dessus de la valeur du signal utile (S1).
